# EUROPEAN PATENT SPECIFICATION

(11) **EP 3 245 313 B1**
(45) Date of publication and mention of the grant of the patent: **05.12.2018**
(21) Application number: 15735976.1
(22) Date of filing: 13.07.2015
(51) Int. Cl.: C23C 14/24, C23C 16/44

(54) **EVAPORATION SOURCE.**
VAKUUMVERDAMPFUNGSQUELLE.
SOURCE D'ÉVAPORATION.

(43) Date of publication of application: 22.11.2017
(73) Proprietor: Applied Materials, Inc., Santa Clara, CA 95054 (US)
(72) Inventor: BANGERT, Stefan, 36396 Steinau (DE); DIEGUEZ-CAMPO, Jose Manuel, 63457 Hanau (DE); KELLER, Stefan, 63814 Mainaschaff (DE); SPATZ, Norbert, 63875 Mespelbrunn (DE)
(74) Representative: Zimmermann & Partner Patentanwälte mbB
(86) International application number: PCT/EP2015/065988
(87) International publication number: WO 2017/008838

(56) References cited:
- EP-A2- 1 783 246
- US-A- 5 932 294
- US-A1- 2012 122 276

## Description

### TECHNICAL FIELD OF THE INVENTION

Embodiments of the present invention relate to deposition of metallic materials, e.g. for OLED manufacturing. In particular, embodiments relate to evaporation of metals and metal alloys. Specifically, embodiments relate to an evaporation source for metals or metal alloys, an evaporation source array for metals or metal alloys, and method of operating an evaporation source.

### BACKGROUND OF THE INVENTION

Metallic evaporators are tools used for the production of organic light-emitting diodes (OLED). OLEDs are a special type of light-emitting diodes in which the emissive layer comprises a thin-film of certain organic compounds. Organic light emitting diodes (OLEDs) are used in the manufacture of television screens, computer monitors, mobile phones, other hand-held devices, etc., for displaying information. OLEDs can also be used for general space illumination. The range of colors, brightness, and viewing angles possible with OLED displays is greater than that of traditional LCD displays because OLED pixels directly emit light and do not require a back light. Therefore, the energy consumption of OLED displays is considerably less than that of traditional LCD displays. Further, the fact that OLEDs can be manufactured onto flexible substrates results in further applications. A typical OLED display, for example, may include layers of organic material situated between two electrodes that are all deposited on a substrate in a manner to form a matrix display panel having individually energizable pixels. The OLED is usually placed between two glass panels, and the edges of the glass panels are sealed to encapsulate the OLED therein.

OLED displays or OLED lighting applications include a stack of several organic materials and metal or metal alloys, which are for example evaporated in a vacuum. For the fabrication of OLED stacks co-evaporation of two or more metals or metal alloys can be desired.

A typical OLED display, for example, may include layers of organic material situated between two electrodes that are all deposited on a substrate. One of these electrodes consists of a transparent conductive layer such as ITO or other transparent conductive oxide materials (TCO). The second electrode consists of a metal or a metal alloy. As a protective layer or a layer for reducing electron affinity, often a very thin layer of lithium fluoride between the cathode and the electron transport layer, cesium fluoride or silver can be deposited.

In light of the high temperature of the metal evaporation, thermal load on the substrates and/or other components during OLED manufacturing can be high. Accordingly, an improved metal or metal alloy evaporation device and an improved metal or metal alloy evaporation is desired.
US 2012/122276 A1, EP 1 783 246 A1, and US 5 932 294 A all disclose evaporation crucibles.

### SUMMARY OF THE INVENTION

In light of the above, an evaporation source for a metal or a metal alloy according to claim 1, an evaporation source array according to claim 12, and a method of operating an evaporation source array according to claim 15 are provided. Further advantages, features, aspects and details are evident from the dependent claims, the description and the drawings.

According to an embodiment, an evaporation source for a metal or a metal alloy is provided. The evaporation source includes an evaporation crucible, wherein the evaporation crucible is configured to evaporate the metal or metal alloy, a distribution pipe with one or more outlets provided along the length of the distribution pipe, wherein the distribution pipe is in fluid communication with the evaporation crucible, wherein the distribution pipe further comprises a first outer tube and a first inner tube, and wherein the distribution pipe and the evaporation crucible are provided as one single piece.

According to another embodiment, the evaporation crucible of the evaporation source can further include a second outer tube and a second inner tube wherein the second outer tube and the second inner tube of the evaporation crucible are provided as a portion of the one single piece. The single piece is provided, for example, by welding, sintering, or another non-detachable conjunction. According to yet another embodiment, the distribution pipe can further include a first heating element which is arranged inside the first inner tube and/or wherein the evaporation crucible further includes a second heating element which is arranged inside the second inner tube wherein the evaporation crucible and the distribution pipe can be made of molybdenum or tantalum.

The evaporation source can further include one or more outlets, wherein the one or more outlets are nozzles extending along an evaporation direction. The evaporation direction of the one or more outlets can be essentially horizontal. The distribution pipe of the evaporation source can be a vapor distribution showerhead including the one or more outlets, particularly the vapor distribution showerhead is a linear vapor distribution showerhead providing a linear source for vapor of the metal or metal alloy. According to yet a further embodiment, the distribution pipe of the evaporation source can include an opening which is sealable with a screw or bolt for filling of evaporation material into the evaporation source or into the crucible, respectively. Further, the distribution pipe of the evaporation source can have a non-circular cross-section perpendicular to the length of the distribution pipe having a main section corresponding to a portion of a triangle, particularly wherein the cross-section perpendicular to the length of the distribution pipe is triangular with rounded corners and/or cut-off corners.

According to another embodiment, an evaporation source array for metals or metal alloys is provided. The evaporation source array includes a first evaporation source and at least a second evaporation source, wherein at least a first outlet of the one or more outlets of the first evaporation source and at least a second outlet of the one or more outlets of the second evaporation source have a distance of 25 mm or less. The evaporation source array can be configured such that the distribution pipes are rotatable around an axis during evaporation and further include one or more supports for the distribution pipes, wherein the support is connectable to a first drive or includes the first drive, wherein the first drive is configured for a translational movement of the one or more supports and the distribution pipes.

Embodiments are also directed at apparatuses for carrying out the disclosed methods and include apparatus parts for performing each described method or process. These methods or processes may be performed by way of hardware components, a computer programmed by appropriate software, by any combination of the two or in any other manner. Furthermore, embodiments according to the disclosure are also directed at methods for operating the described apparatus. It includes methods or processes for carrying out every function of the apparatus. According to the methods described herein, the evaporated material of the first evaporation source is silver (Ag) and the evaporated material of the second evaporation source is magnesium (Mg), wherein the evaporated material of the first evaporation source and the evaporated material of the second evaporation source is evaporated in a ratio of 1:1 ≤ Ag : Mg ≤ 7:1.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
- FIG. 1: shows a schematic top view of a deposition apparatus for depositing metallic material, e.g. a metal or metal alloy, in a vacuum chamber according to embodiments described herein;
- FIG. 2: shows a view of portions of an evaporation source according to embodiments described herein;
- FIGS. 3A and 3B: show schematic cross-sectional views of portions of an evaporation source or an evaporation pipe, respectively, according to embodiments described herein;
- FIG. 4: shows a schematic cross-sectional top view of an array of two evaporation sources or two evaporation pipes, respectively, according to embodiments described herein;
- FIG. 5A to 5C: show schematic cross-sectional views of portions of an evaporation source or an evaporation pipe, respectively, according to embodiments described herein;
- FIG. 6: shows a schematic cross-sectional view of a portion of an evaporation source or an evaporation pipe, respectively, according to embodiments described herein;
- FIG. 7A: shows a schematic view of a portion of an evaporation pipe according to embodiments described herein;
- FIGS. 7B and 7C: show schematic views of portions of an array of openings in shields according to embodiments described herein;
- FIG. 8: shows a schematic view of a portion of an evaporation source according to embodiments described herein;
- FIGS. 9A and 9B: show schematic cross-sectional views of portions of an evaporation source or an evaporation pipe, respectively, according to embodiments described herein;
- FIG. 10A: shows a schematic view of another evaporation source according to embodiments described herein;
- FIG. 10B: shows a schematic view of yet another evaporation source according to embodiments described herein;
- FIGS. 11A and 11B: show schematic views of a deposition apparatus for depositing organic material in a vacuum chamber according to embodiments described herein and evaporation sources for evaporation of organic material according to embodiments described herein in different deposition positions in a vacuum chamber; and
- FIG. 12: shows a flow chart of a method for depositing of a metallic material, e.g. a metal or a metal alloy, with a distribution pipe according to embodiments described herein.

### DETAILED DESCRIPTION OF EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. Further, features illustrated or described as part of one embodiment can be used on or in conjunction with other embodiments to yield yet a further embodiment. It is intended that the description includes such modifications and variations.

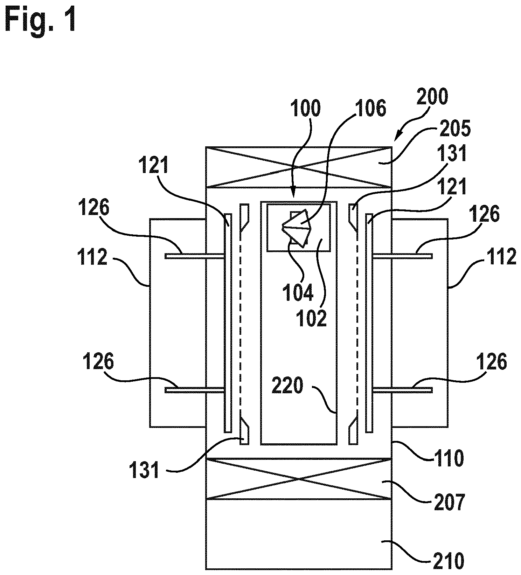

FIG. 1 shows an evaporation source 100 in a position in a vacuum chamber 110. According to some embodiments, which can be combined with other embodiments described herein, the evaporation source is configured for a translational movement and a rotation around an axis. The evaporation source 100 has one or more evaporation crucibles 104 and one or more distribution pipes 106. Two evaporation crucibles and two distribution pipes are shown in FIG. 1, wherein the evaporation crucibles and the distribution pipes can be provided on a support 102. The distribution pipes 106 with the evaporation crucibles 104 are supported by the support 102. Two substrates 121 are provided in the vacuum chamber 110. Metallic material, e.g. a metal or metal alloy, is evaporated from the distribution pipes 106.

According to embodiments described herein, the substrates are coated with metallic material in an essentially vertical position. For example, the metallic material can be a metal or metal alloy, such as calcium, aluminum, barium, ruthenium, magnesium-silver alloy, silver, or combinations thereof. The view shown in FIG. 1 is a top view of an apparatus including the evaporation source 100. Typically, the distribution pipe is a vapor distribution showerhead, particularly a linear vapor distribution showerhead. The distribution pipe provides a line source extending essentially vertically. According to embodiments described herein, which can be combined with other embodiments described herein, essentially vertically is understood particularly when referring to the substrate orientation, to allow for a deviation from the vertical direction of 20° or below, e.g. of 10° or below. This deviation from the vertical direction can be used to reduce particle generation on the substrate or layers deposited thereon. Alternatively, the deviation can be provided for example because a substrate support with some deviation from the vertical orientation might result in a more stable substrate position. Yet, the substrate orientation during deposition of the metallic material is considered essentially vertical, which is considered different from the horizontal substrate orientation. The surfaces of the essentially vertical oriented substrates are coated by a line source extending in one direction corresponding to one substrate dimension and a translational movement along the other direction corresponding to the other substrate dimension.

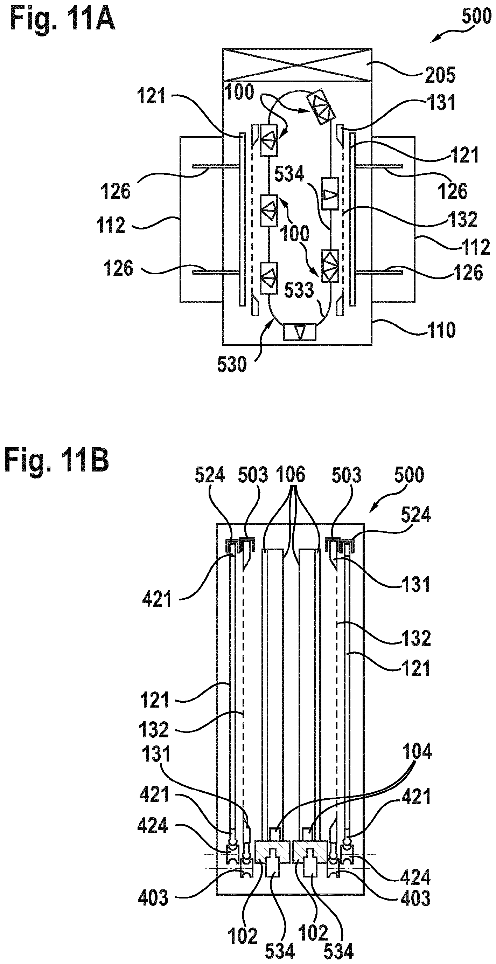

FIG. 1 illustrates an embodiment of a deposition apparatus 200 for depositing metallic material, e.g. metals or metal alloys, in a vacuum chamber 110. The evaporation source 100 is provided in the vacuum chamber 110 on a track, e.g. a looped track (as e.g. shown in FIG. 11A) or linear guide 220. The track or the linear guide 220 is configured for the translational movement of the evaporation source 100. According to different embodiments, which can be combined with other embodiments described herein, a drive for the translational movement can be provided in the evaporation source 100, at the track or linear guide 220, within the vacuum chamber 110 or a combination thereof.

FIG. 1 shows a valve 205, for example a gate valve. The valve 205 allows for a vacuum seal to an adjacent vacuum chamber (not shown in FIG. 1). The valve can be opened for transport of a substrate 121 or a frame 131 into the vacuum chamber 110 or out of the vacuum chamber 110. Frame 131 can support a mask masking the edges of the substrate 121.

According to some embodiments, which can be combined with other embodiments described herein, a further vacuum chamber, such as maintenance vacuum chamber 210 is provided adjacent to the vacuum chamber 110. The vacuum chamber 110 and the maintenance vacuum chamber 210 are connected with a valve 207. The valve 207 is configured for opening and closing a vacuum seal between the vacuum chamber 110 and the maintenance vacuum chamber 210. The evaporation source 100 can be transferred to the maintenance vacuum chamber 210 while the valve 207 is in an open state. Thereafter, the valve can be closed to provide a vacuum seal between the vacuum chamber 110 and the maintenance vacuum chamber 210. If the valve 207 is closed, the maintenance vacuum chamber 210 can be vented and opened for maintenance of the evaporation source 100 without breaking the vacuum in the vacuum chamber 110. Accordingly, it may also be possible to operate the evaporation source 100 in the vacuum chamber 110, while the maintenance vacuum chamber 210 is vented for maintenance purposes.

Two substrates 121 are supported on respective transportation tracks within the vacuum chamber 110. Further, two tracks for providing frames 131, e.g. frames of masks, are provided thereon. Coating of the substrates 121 can be masked by respective masks, which may be supported by frames 131. According to typical embodiments, the frames 131, i.e. a first frame corresponding to a first substrate and a second frame corresponding to a second substrate, are provided in a predetermined position.

According to some embodiments, which can be combined with other embodiments described herein, a substrate 121 can be supported by a substrate support 126, which is connected to an alignment unit 112. An alignment unit 112 can adjust the position of the substrate 121 with respect to the frame 131. FIG. 1 illustrates an embodiment where the substrate support 126 is connected to an alignment unit 112. Accordingly, the substrate is moved relative to the frame 131 and/or a mask in order to provide for a proper alignment between the substrate and the frame during deposition of the metallic material. Either the frame and/or mask can be positioned relative to the substrate 121 or the frame 131 and the substrate 121 can both be positioned relative to each other. The alignment units 112, which are configured for adjusting the position between a substrate 121 and a frame 131 relative to each other, allow for a proper alignment of the frame during the deposition process, which is beneficial for high quality of OLED display manufacturing.

Examples of an alignment of a frame and a substrate relative to each other include alignment units, which allow for a relative alignment in at least two directions defining a plane, which is essentially parallel to the plane of the substrate and the plane of the frame. For example, an alignment can at least be conducted in an x-direction and a y-direction, i.e. two Cartesian directions defining the above-described parallel plane. Typically, the frame and the substrate can be essentially parallel to each other. Specifically, the alignment can further be conducted in a direction essentially perpendicular to the plane of the substrate and the plane of the frame. Thus, an alignment unit is configured at least for an X-Y-alignment, and specifically for an X-Y-Z-alignment of the frame and the substrate relative to each other. One specific example, which can be combined with other embodiments described herein, is to align the substrate in x-direction, y-direction and z-direction to a frame, which can be held stationary in the vacuum chamber 110.

As shown in FIG. 1, the linear guide 220 provides a direction of the translational movement of the evaporation source 100. On both sides of the evaporation source 100, the substrates 121 at the opposing sides of the evaporation source 100 can extend essentially parallel to the direction of the translational movement. According to typical embodiments, a substrate 121 can be moved into the vacuum chamber 110 and out of the vacuum chamber 110 through valve 205. A deposition apparatus 200 can include a respective transportation track for transportation of each of the substrates 121. For example, the transportation track can extend parallel to the substrate position shown in FIG. 1 and into and out of the vacuum chamber 110.

Typically, further tracks are provided for supporting the frames 131. Accordingly, some embodiments, which can be combined with other embodiments described herein, can include four tracks within the vacuum chamber 110. In order to move one of the frames 131 out of the chamber, for example for cleaning of the frame 131, the frame can be moved onto the transportation track of the substrate 121. The respective frame can then exit or enter the vacuum chamber 110 on the transportation track for the substrate. Even though it would be possible to provide a separate transportation track into and out of the vacuum chamber 110 for the frames 131, the costs of ownership of a deposition apparatus 200 can be reduced if only two tracks, i.e. transportation tracks for a substrate, extend into and out of the vacuum chamber 110 and, in addition, if the frames 131 can be moved onto a respective one of the transportation tracks for the substrate by an appropriate actuator or robot.

FIG. 1 illustrates an exemplary embodiment of the evaporation source 100. The evaporation source 100 includes a support 102. The support 102 is configured for the translational movement along the linear guide 220. The support 102 can support one or more, e.g. two, evaporation crucibles 104 and one or more, e.g. two, distribution pipes 106 provided over the evaporation crucible 104. According to embodiments described herein, which can be combined with other embodiments described herein, the distribution pipe and the evaporation crucible are provided as one single piece. In this single piece, the vapor generated in the evaporation crucible can move upwardly and out of the one or more outlets of the distribution pipe. According to embodiments described herein, the distribution pipe 106 can also be considered a vapor distribution showerhead, for example a linear vapor distribution showerhead.

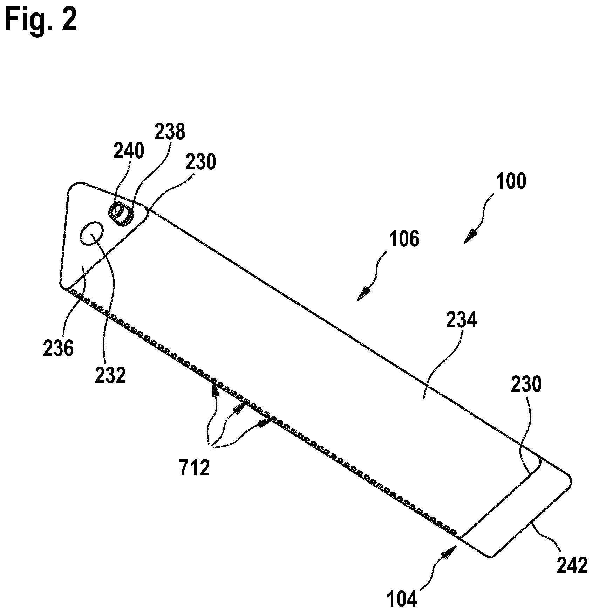

FIG. 2 shows a view of portions of an evaporation source according to embodiments described herein. An evaporation source can include a distribution pipe 106 and an evaporation crucible 104. The evaporation crucible 104 can be fixed to the first end of the distribution pipe 106 in a non-detachable manner e.g. by welding. Accordingly, the evaporation crucible 104 and the distribution pipe 106 are provided as a single piece. There are no gaps or slits at the contact areas allowing for a hermetically closed contact area 230. According to embodiments described herein, there are no gaps and/or slits between the evaporation crucible and the distribution pipe. Particularly, the interior of the evaporation crucible and the interior of the distribution pipe form one common hollow space. The hollow space is without gaps or slits, e.g. gaps or slits between the evaporation crucible and the distribution pipe. Without providing the evaporation crucible and the distribution pipe as one single piece, gaps or slits might be present at the contact area 230 between the evaporation crucible 104 and the distribution pipe 106. For example, the evaporation crucible and the distribution pipe can be welded to each other, such that gaps or slits in the contact area of the evaporation crucible and the distribution pipe can be avoided.

At the second end of the distribution pipe 106 opposing the first end, a closure plate 236 can be fixed in a non-detachable manner e.g. by welding such that there are also no gaps or slits in order to get a hermetically closed contact area 230. The cover plate 236 can be provided with an opening or aperture 238 for filling evaporation material into the evaporation source 100 or the evaporation crucible 104, respectively. This opening or aperture 238 can detachably be sealed in a vapor tight manner by a closure 240 such as a screw, a bolt, a plug or any suitable seal. According to some embodiments, one opening or aperture can be provided for filling the evaporation source 100 or the evaporation crucible 104 with the evaporation material. Yet, also more than one opening or aperture can be provided. Accordingly, the hollow space, provided by providing the evaporation crucible and the distribution pipe as a single piece, is open to the outside only at one or more openings or apertures for filling the evaporation source 100 or the evaporation crucible 104 with the evaporation material and at the one or more outlets 712, e.g. nozzles. The one or more outlets 712 direct the evaporated material, e.g. metal vapor or metal alloy vapor to the substrate. According to embodiments, which can be combined with other embodiments described herein, the hollow space or volume, in which the deposition material can be provided is provided between the distribution pipe and an inner tube within the distribution pipe and/or provided between the crucible wall and an inner tube within the crucible.

According to an embodiment, the distribution pipe 106 can be an elongated pipe with a first inner tube 232 and a first outer tube 234, as shown in FIG. 2. The first inner tube 232 can be formed as a cylinder having one closed end and one open end. The first inner tube 232, the first outer tube 234, and the closure 236 can be welded to form one single piece. Further, the first inner tube 232, the first outer tube 234, the closure 236, and the crucible 104 can be welded to form an evaporation source 100 as one single piece.

According to embodiments described herein, the evaporation source 100 includes a distribution pipe 106 and an evaporation crucible 104, wherein the distribution pipe and the evaporation crucible are provided as one single piece. The evaporation source formed as one single piece provides a closed housing or border of a volume of the evaporation source having no slits or gaps. The benefit of this architecture or design is that it prevents the liquid metal or metal vapor from flowing into slits or gaps. There are metals known, the wettability of which may cause a flow through such slits or gaps. Such liquid metals crawl, creep, flow or seep through the slits or gaps and arrive at the outside of the evaporation source. A result may be a pollution or contamination of the interior of the coating machine or a destruction of sensitive machine parts. Further, liquid metal could cause electrical shorts.

According to embodiments described herein, providing the distribution pipe and the evaporation crucible as one single piece without slits or gaps may be understood herein as that these parts are joined together in a non-detachable way for example by welding, sintering, soldering, brazing, manufacturing from a single piece, pressure welding or press fitting, 3D printing, bonding, causing fusion, or other appropriate means.

According to embodiments, which can be combined with other embodiments described herein, the distribution pipe 106 comprises a first outer tube 234 and a first inner tube 232. The first outer tube and the first inner tube of the distribution pipe may be joined together in a non-detachable way e.g. by welding or any other appropriate means described above to form one single piece without slits or gaps. Further, the distribution pipe comprises a first heating element 715 which is arranged inside the first inner tube 232. A portion of the hollow space, closed housing or a volume of the evaporation source is formed between the walls of the first outer tube and the first inner tube. Accordingly, the first heating element is not within the hollow space, closed housing or a volume of the evaporation source, in which the material for layer deposition is provided. Yet, the first heating element is within the first outer tube and the first inner tube.

According to another embodiment, which can be combined with other embodiments described herein, the evaporation crucible 104 comprises a second outer tube 248 and a second inner tube 244. The second outer tube and the second inner tube of the evaporation crucible may be joined together in a non-detachable way e.g. by welding or any other appropriate means as described above to form one single piece without slits or gaps. Further the evaporation crucible comprises a second heating element 725 which is arranged inside the second inner tube. A further portion of the hollow space, closed housing or a volume of the evaporation source is formed between the walls of the second outer tube and the second inner tube. Accordingly, the second heating element is not within the hollow space, closed housing or a volume of the evaporation source, in which the material for layer deposition is provided. Yet, the second heating element is within the second outer tube and the second inner tube.

The distribution pipe further comprises one or more outlets which may be formed as nozzles. The one or more outlets or nozzles extend along an evaporation direction. The evaporation direction can be essentially horizontal. The distribution pipe can be a vapor distribution showerhead having one or more outlets. In particular, the vapor distribution showerhead can be a linear vapor distribution showerhead providing a linear source for metallic vapor. According to an embodiment, the one or more outlets of the evaporation source have a distance of 25 mm or less. Further, the opening of the one or more outlets or nozzles of the evaporation source have a cross-section of 1 mm to 6 mm in diameter, for example between 1 mm to 3 mm.

The distribution pipe further comprises one or more openings for filling the evaporation source 100 or the evaporation crucible 104 with evaporation material. This opening for filling the evaporation source 100 or the evaporation crucible 104 with evaporation material may be sealable with a screw or bolt. Sealable may be understood here as a vapor tight closure which is detachable for filling the evaporation source or the evaporation crucible with evaporation material. The vapor tight sealing may be realized by using a lid or cap. The lid or cap can be provided by a screw or a bolt. According to some embodiments, which can be combined with other embodiments described herein, the lid or cap can be made of graphite. According to another embodiment, the evaporation crucible can be made of molybdenum or tantalum. According to a further embodiment, the distribution pipe can be made of molybdenum or tantalum. Further it is possible to manufacture the nozzle bar of molybdenum or tantalum. According to yet a further embodiment, the evaporation crucible, the distribution pipe and the nozzle bar can be made of molybdenum or tantalum.

According to another embodiment, which can be combined with other embodiments described herein, the evaporation source can be formed such that the distribution pipe has a non-circular cross-section perpendicular to the length of the distribution pipe. The evaporation source can have a main section corresponding to a portion of a triangle. The cross-section perpendicular to the length of the distribution pipe can be triangular with rounded corners and/or cut-off corners as a triangle. Further, the evaporation source can have a cross-section of a triangle.

The above described design provides the possibility to combine a first and a second evaporation source to form an array. An array of evaporation sources can be used to yield an increased evaporation rate of the metal or metal alloy. Further, an array of evaporation sources can be used for co-evaporation of two different metals or metal alloys. According to an embodiment, which can be combined with other embodiments described herein, the array of evaporation sources can be arranged such that the evaporation direction of the one or more outlets of each evaporation source is inclined to a symmetrical plane provided along the length of the distribution pipe. For example, the inclination angle of the distribution source, e.g. the angle at which the main evaporation direction of the evaporation source emits relative to the surface orthogonal of the substrate surface can be 20° or below, for example between 3° and 10°. This orientation of the one or more outlets or nozzles provides the possibility to realize a shorter distance between the array of evaporation sources and the substrate.

According to an embodiment, the evaporated material of the first evaporation source can be silver (Ag) and the evaporated material of the second evaporation source can be magnesium (Mg). The first and second evaporated material can be evaporated in a ratio between 1:2 ≤ Ag : Mg ≤ 7:1, particularly between 1:1 ≤ Ag : Mg ≤ 5:1.

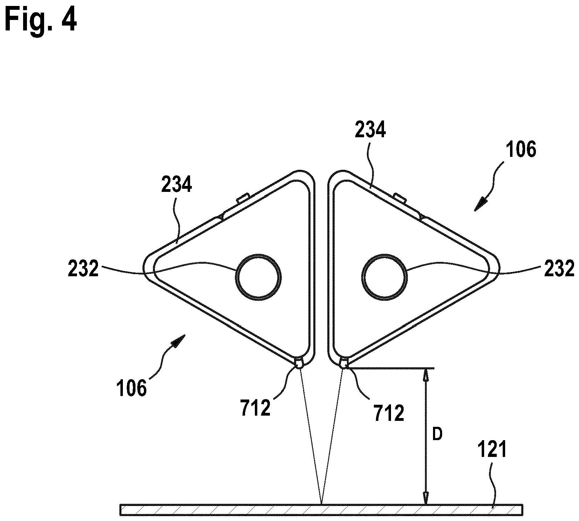

According to embodiments described herein, an evaporation source includes one or more evaporation crucibles and one or more distribution pipes, wherein a respective one of the one or more distribution pipes can be in fluid communication with the respective one of the one or more evaporation crucibles. Various applications for OLED device manufacturing include processes, wherein one or more metallic materials are evaporated simultaneously. Accordingly, as for example shown in FIG. 4, two distribution pipes and corresponding evaporation crucibles, each as a single piece, can be provided next to each other. Accordingly, the evaporation source 100 may also be referred to as an evaporation source array, e.g. wherein more than one kind of metallic material is evaporated at the same time. As described herein, the evaporation source array itself can be referred to as an evaporation source for two or more metallic materials, e.g. metals or metal alloys.

As described herein, evaporation sources for metallic materials or evaporation source arrays, respectively, can be improved with respect to the desire to deposit different metals independently from one another or in combination. Evaporation sources evaporating two or more metallic materials from the same crucible may suffer from an insufficient mixture of the metallic alloy materials when depositing the two or more metallic alloy materials on a substrate. Accordingly, it is desirable to improve mixing of metallic alloy materials for applications, for which, for example, two different metallic materials are deposited to provide one metallic alloy layer on a substrate.

The one or more outlets of the distribution pipe can be one or more openings or one or more nozzles, which can, e.g., be provided in a showerhead or another vapor distribution system. The evaporation source can include a vapor distribution showerhead, e.g. a linear vapor distribution showerhead having a plurality of nozzles or openings. A showerhead can be understood herein as including an enclosure having openings such that the pressure in the showerhead is higher than that outside of the showerhead, for example by at least one order of magnitude higher.

According to embodiments described herein, which can be combined with other embodiments described herein, the rotation of the distribution pipe can be provided by a rotation of an evaporator control housing, on which the evaporation crucible and the distribution pipe are mounted. For example, the evaporation crucible and the distribution pipe can be provided as one single piece by welding. Additionally or alternatively, the rotation of the distribution pipe can be provided by moving the evaporation source along the curved portion off a looped track (see, for example, FIG. 11A). Accordingly, the evaporation sources include a distribution pipe and an evaporation crucible, which may both be rotatably mounted, i.e. together.

According to some embodiments, which can be combined with other embodiments described herein, the evaporation source includes a distribution pipe (e.g. an evaporation tube). The distribution pipe may have a plurality of openings, such as an implemented nozzle array. Further, the evaporation source includes a crucible, which contains the evaporation material. According to some embodiments, which can be combined with other embodiments described herein, the distribution pipe or evaporation tube can be designed in a triangular shape so that it is possible to bring the openings or the nozzle arrays as close as possible to each other. This allows for achieving an improved mixture of the different metallic materials, e.g. for the case of the co-evaporation of two, three or even more different metallic materials.

According to yet further embodiments, which can additionally or alternatively be implemented, evaporation sources described herein reduce a temperature rise of the substrates on which temperature sensitive organic materials have been deposited. This can be, for example, below 5 Kelvin, or even below 1 K. The reduction of the heat transfer from evaporation source to the substrate can be provided by an improved cooling. Additionally or alternatively, in light of the triangular shape of the evaporation source, the area, which radiates towards the substrate, is reduced. Additionally, a stack of metal plates, for example up to 10 metal plates, can be provided to reduce the heat transfer from the evaporation source to the substrate. According to some embodiments, which can be combined with other embodiments described herein, the heat shields or metal plates can be provided with orifices for the outlet or nozzles and may be attached to at least the front side of the source, i.e. the side facing the substrate.

According to typical embodiments, which can be combined with other embodiments described herein, distribution pipe 106 provides a line source. For example, a plurality of openings and/or outlets 712 such as nozzles, are arranged along at least one line. According to an alternative embodiment, one elongated opening extending along the at least one line can be provided. For example, the elongated opening can be a slit. According to some embodiments, which can be combined with other embodiments described herein, the line extends essentially vertically. For example, the length of the distribution pipe 106 or the length of the plurality of openings and/or outlets corresponds at least to the height of the substrate to be deposited in the deposition apparatus. In many cases, the length of the distribution pipe 106 or the length of the plurality of openings and/or outlets will be longer than the height of the substrate to be deposited, at least by 10% or even 20%. According to some embodiments, which can be combined with other embodiments described herein, the length of the distribution pipe or the length of the plurality of openings and/or outlets can be provided with a constant protrusion or overhang **P** to the height **H** of the substrate such that the total length of the distribution pipe or the length of the plurality of openings and/or outlets is given by **H** + 2·**P**. By this constant protrusion or overhang, a uniform deposition at the upper end of the substrate and/or the lower end of the substrate can be provided.

According to some embodiments, which can be combined with other embodiments described herein, the length of the distribution pipe can be 1.3 m or above, for example 2.5 m or above. According to one configuration, as shown in FIG. 2, the evaporation crucible 104 is provided at the lower end of the distribution pipe 106. The metallic material is evaporated in the evaporation crucible 104. The vapor of metallic material enters the distribution pipe 106 at the bottom of the distribution pipe and is guided essentially sideways through the plurality of openings in the distribution pipe, e.g. towards an essentially vertical substrate.

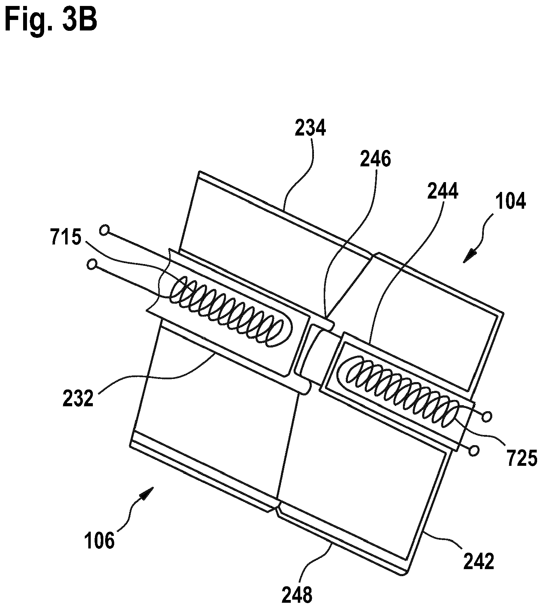

According to some embodiments, which can be combined with other embodiments described herein, the outlets (e.g. nozzles) are arranged to have a main evaporation direction to be horizontal ± 20°. According to some specific embodiments, the evaporation direction can be oriented slightly upward, e.g. to be in a range from horizontal to 15° upward, such as 3° to 7° upward. Correspondingly, the substrate can be slightly inclined to be substantially perpendicular to the evaporation direction. This slightly inclined orientation of evaporation direction and substrate can reduce undesired particle generation. For illustrative purposes, the evaporation crucible 104 and the distribution pipe 106 are shown without heat shields in FIG. 2. The first heating element 715 and the second heating element 725 can be seen in the schematic perspective view shown in FIG. 3B.

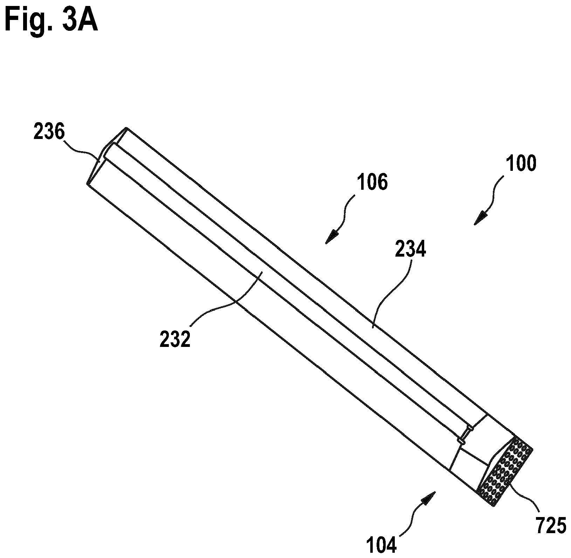

FIGS. 3A and 3B show schematic cross-sectional views of portions of an evaporation source or an evaporation pipe, respectively, according to embodiments described herein. The evaporation crucible can be a reservoir for the metallic material to be evaporated. According to some embodiments, which can be combined with other embodiments described herein, a first heating element can be provided for the distribution pipe and a second heating element can be provided for the evaporation crucible. For example, the first heating element and the second heating element can be provided to heat the distribution pipe and the evaporation crucible, respectively, from within the distribution pipe and the evaporation crucible, respectively. Accordingly, the overall heating power can be reduced, which may in turn result in reduced heat load on a substrate or a mask. Yet, one of the first heating element and the second heating element may also be provided to heat the source from the outside.

FIG. 3A shows a second heating element 725. The second heating element 725 can be provided at the bottom plate 242 of the evaporation crucible 104 or can be configured to encompass the outer portion of the evaporator crucible (not shown). The volume of evaporation crucible 104 can be between 100 cm³ and 3000 cm³, particularly between 700 cm³ and 1700 cm³, more particularly 1200 cm³. First heating element 715 can be arranged inside the inner tube 232 of the distribution pipe 106 and is provided to heat the distribution pipe. Both, first and second, heating elements 715 and 725, respectively, can separately and independently be temperature and/or power controlled. Accordingly, the distribution pipe 106 can be heated to a temperature such that the vapor of the metallic material, which is provided by the evaporation crucible 104, does not condense at the distribution pipe 106, e.g. at an inner portion of the wall of the distribution pipe 106. The evaporation crucible 104 can be heated to a temperature such that the metallic material, e.g. a metal or metal alloy, is evaporated with an appropriate evaporation rate in order to generate and guarantee the flow of metal vapor needed for the intended metal layer thickness deposited on the substrate.

FIG. 3B shows a schematic cross-sectional view of the lower section of an evaporation source or an evaporation pipe, respectively, according to further embodiments described herein. As can be seen from FIG. 3B, according to some embodiments which can be combined with other embodiments described herein, evaporation source 100 comprises a distribution pipe 106 and an evaporation crucible 104. Distribution pipe 106 comprises a first outer tube 234 and a first inner tube 232. Evaporation crucible 104 comprises a second outer tube 248, a second inner tube 244, and a bottom plate 242. Both inner tubes 232 and 244 can be formed as cylinders having one closed end and one open end. The cylinder may have an arbitrary shape of the cross-section, such as circular, oval, triangular, quadrangular, hexagonal, or polyangular. Yet, a circular cylinder provides a heat radiation with a higher symmetry. The first heating element 715 for heating the distribution pipe 106 can be arranged inside the first inner tube 232. The second heating element 725 for heating crucible 104 can be arranged inside the second inner tube 244. The first and/or second heating element may be electric heating elements as exemplarily shown in FIG. 3B.

Placing the heating elements inside the inner tubes 232 and 244 reduces heat loss to areas outside of the evaporation source. Accordingly, the overall heating power can be reduced, which may in turn reduce the heat load on a substrate or a mask. Further, having heating elements inside of the tubes can result in thermal expansion of e.g. rod like heating elements which leads to an improved thermal contact between the heating elements and the inner tubes of the distribution pipe and the crucible. Thus, it can be assured that the heating power is effectively transferred from the first and second heating elements 715 and 725 to the first inner tube 232 of the distribution pipe and the second inner tube 244 of the crucible, respectively. Further, a thermal damage of the heating elements is prevented which can occur if the heating elements which are placed in vacuum during operation have a low thermal contact to the object to be heated and cannot dissipate the heat. According to an embodiment which can be combined with other embodiments described herein, the heating elements can exhibit a greater thermal expansion or greater thermal expansion coefficient than the inner tubes. Accordingly, upon heating of the heating element and improved thermal contact between a heating element and an inner tube occurs.

First inner tube 232 of distribution pipe 106 and second inner tube 244 of crucible 104 can have a surface 246 at which both closed ends are facing each other. According to an embodiment, the first inner tube 232 of the distribution pipe 106 and the second inner tube 244 of the evaporation crucible 104 may face each other without being in mechanical contact. According to another embodiment, the first inner tube 232 of the distribution pipe and the second inner tube 244 of the evaporation crucible may be in mechanical contact. At surface 246, the inner tubes 232 and 244 can be in direct contact or in indirect contact. The closed ends can provide a recess and a protrusion. For example, recess and protrusion may be formed like slot and key. At surface 246, the first and second inner tubes 232 and 244 can be provided with a volume which is enclosed by recess and protrusion. This volume can be empty or can be filled with a material exhibiting a low thermal conductance in order to thermally separate the heat control of the first and second heating elements 715 and 725. According to some embodiments, which can be combined with other embodiments described herein, the inner tubes 232 and 244 can be made of two different parts which are in floating contact wherein the ends provided with recess and protrusion, e.g. slot and key, of both inner tubes are provided with enough space for thermal expansion.

According to yet another embodiment, the first inner tube 232 of the distribution pipe and the second inner tube 244 of the evaporation crucible may be in direct but detachable mechanical contact. Slits or gaps between the first inner tube 232 of the distribution pipe and the second inner tube 244 of the evaporation crucible do not affect the functionality of the evaporation source 100. At this part of the evaporation source, there is no opening to outside of the evaporation source. Each of the first and second inner tubes is hermetically closed at this end. The first and second inner tubes exhibit an opening at the ends opposing these ends for placing first and second heating elements 715 and 725 inside the first and second inner tubes. By joining the open end of the first inner tube 232 to the closure plate 236 at the closed end of the distribution pipe 106 in a non-detachable way as described above, there is no slit, gap or opening to outside the evaporation source 100. The same applies for the second inner tube 244 at the bottom plate 242 of evaporation crucible 104.

According to yet a further embodiment, the first inner tube 232 of the distribution pipe 106 and the second inner tube 244 of the evaporation crucible 104 may be joined together in a non-detachable way e.g. by welding or any other appropriate means as described above to form one single piece. Forming both, the first and second inner tubes as one single piece provides the possibility to join it to the distribution pipe and the evaporation crucible, respectively, by welding, soldering or another non-detachable way without having one further assembling action. Alternatively, the inner tubes 232 and 244 can be made as one single piece. This combined inner tube can be welded on closure plate 236, the outer tubes 234 and 248 and bottom plate 242 to form evaporation source 100 as one single piece.

The above described embodiments provide an evaporation source 100 made of one piece providing a closed evaporation volume without openings like slits or gaps except for the intended apertures for filling evaporation material 240 in the distribution pipe 106 or the evaporation crucible 104, respectively. Further, there are one or more openings or nozzles for directing the vapor to the substrate.

FIG. 4 shows a schematic cross-sectional top view of an array of two evaporation sources or two evaporation pipes, respectively, according to embodiments described herein. Distribution pipes 106 provide a line source. First inner tubes 232 can be arranged inside the first outer tubes 234 of the distribution pipes 106. For example, a plurality of openings and/or outlets 712 such as nozzles, are arranged along at least one line. According to an alternative embodiment, one elongated opening extending along the at least one line can be provided on each distribution pipe 106. For example, the elongated opening can be a slit. According to some embodiments, which can be combined with other embodiments described herein, the lines extend essentially vertically i.e. in FIG. 4 along lines extending into the drawing plane. As can be seen from FIG. 4, the openings and/or outlets 712, such as nozzles, of each distribution pipe are arranged such that the evaporation direction of the one or more openings and/or outlets 712 is arranged inclined to a symmetrical plane provided along the length of each distribution pipe. The angles of inclination can be adapted such that the centers of the beams of evaporated material meet each other when they have covered the distance between the openings or nozzles and the substrate 121 which can be located with distance **D** to the openings or nozzle array of the distribution pipes 106. According to an embodiment, which can be combined with other embodiments described herein, the substrate 121 can be held in a fixed position and the array of the distribution pipes 106 are moved along a transportation line parallel to the substrate surface provided by the linear guide 220.

The distance **D** between the substrate and the openings or nozzle array of the distribution pipe 106 may be 500 mm or below, such as 145 mm or below. For example, the distance D can be from 50 mm to 1000 mm, particularly from 50 mm to 500 mm.

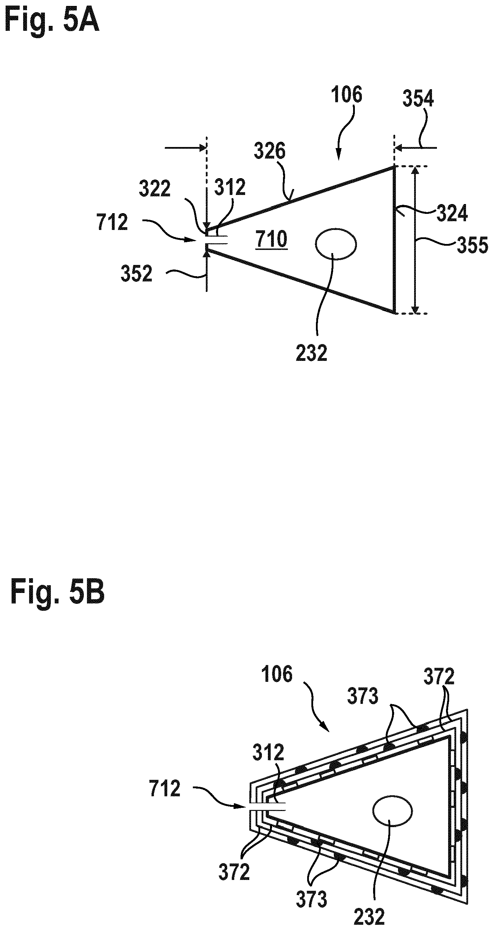

FIG. 5A shows a cross-section of a distribution pipe 106. The distribution pipe 106 has walls 322, 326, and 324, which surround an inner hollow space 710. The first inner tube 232 is arranged within the outer tube. The wall 322 is provided at an outlet side of the evaporation crucible, at which the outlets 712 are provided. According to some embodiments, which can be combined with other embodiments described herein, and outlet 712 can be provided by the nozzle 312. The cross-section of the distribution pipe can be described as being essentially triangular, that is the main section of the distribution pipe corresponds to a portion of a triangle and/or the cross-section of the distribution pipe can be triangular with rounded corners and/or cut-off corners. As shown in FIG. 5A, for example the corner of the triangle at the outlet side is cut off.

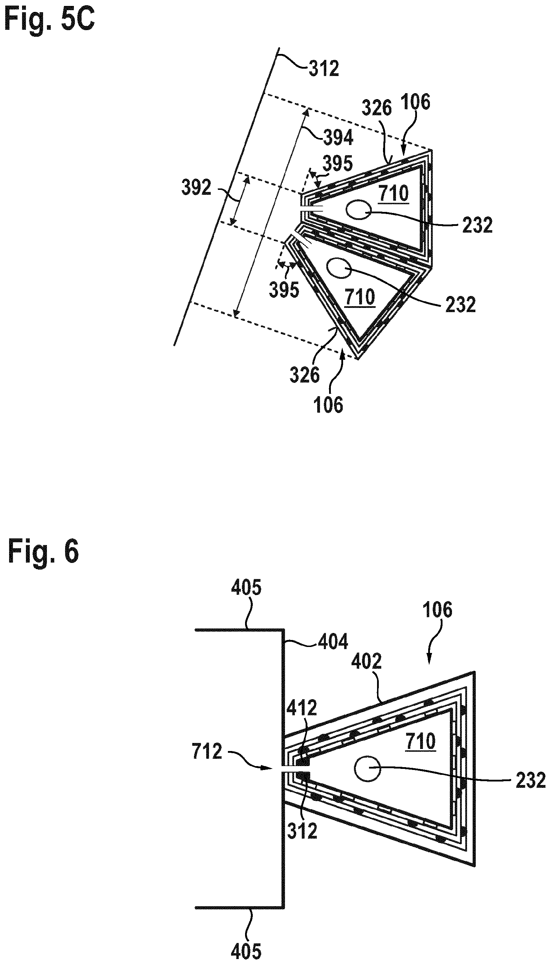

The width of the outlet side of the distribution pipe, e.g. the dimension of the wall 322 in the cross-section shown in FIG. 5A, is indicated by arrow 352. Further, the other dimensions of the cross-section of the distribution pipe 106 are indicated by arrows 354 and 355. According to embodiments described herein, the width of the outlet side of the distribution pipe is 30% or less of the maximum dimension of the cross-section, e.g. 30% of the larger dimension of the dimensions indicated by arrows 354 and 355. In light thereof, outlet 712 of neighboring distribution pipes 106 can be provided at a smaller distance. The smaller distance improves mixing of metallic materials, which are evaporated next to each other. This can be better understood when referring to FIGS. 5C, 9A, 9B, 10A and 10B. Yet further, additionally or alternatively, and independent of the improved mixing of metallic materials, the width of the wall facing the deposition area, or substrate respectively, in an essentially parallel manner, can be reduced. Correspondingly, the surface area of a wall facing a deposition area, or substrate respectively, in an essentially parallel manner, e.g. wall 322, can be reduced. This reduces the heat load provided to a mask or substrate, which are supported in the deposition area or slightly before the deposition area.

According to some embodiments, which can be combined with other embodiments described herein, the product of the length of the distribution pipe and the area of all outlets in the distribution pipe divided by the hydraulic diameter of the distribution pipe, i.e. the value calculated by the formula N*A*L/D, can be 7000 mm² or below, for example 1000 mm² to 5000 mm². In this formula, N is the number of outlets in the distribution pipe, A is the cross-section area of one outlet, L is the length of the distribution pipe, and D is the hydraulic diameter of the distribution pipe.

FIG. 5B illustrates further details of the distribution pipe 106 according to some embodiments described herein. The heating elements can be electrical heaters which are arranged inside the first inner tube 232 of the distribution pipe 106 and inside the second inner tube 244 of the evaporation crucible 104. For example, the heating elements can be provided by heating wires, e.g. coated heating wires, which are clamped or otherwise fixed to the inner tubes 232 or 244.

Two or more heat shields 372 are provided around the distribution pipe 106 or the outer tube of the distribution pipe, respectively. For example, the heat shields 372 can be spaced apart from each other. Protrusions 373, which can be provided as spots on one of the heat shields, separate the heat shields with respect to each other. Accordingly, a stack of heat shields 372 is provided. For example, two or more heat shields, such as five or more heat shields or even 10 heat shields can be provided. According to some embodiments, this stack is designed in a way that compensates for the thermal expansion of the source during the process, so that the nozzles are never blocked. According to yet further embodiments, which can be combined with other embodiments described herein, the outermost shield can be water-cooled.

As exemplarily shown in FIG. 5B, the outlet 712, which is shown in the cross-section shown in FIG. 5B, is provided with a nozzle 312. The nozzle 312 extends through the heat shields 372. This can reduce condensation of metallic material at the heat shields, as the nozzle guides the metallic material through this stack of heat shields. The nozzle can be heated to a temperature, which is similar to the temperature inside the distribution pipe 106. In order to improve heating of the nozzle 312, a nozzle support portion 412 can be provided, which is in contact with the heated walls of the distribution pipe, as for example shown in FIG. 6.

FIG. 5C shows an embodiment, where two distribution pipes are provided next to each other. Accordingly, an evaporation source having a distribution pipe arrangement as shown in FIG. 5C can evaporate two metallic materials next to each other. Such an evaporation source can thus also be referred to as an evaporation source array. As shown in FIG. 5C, the shape of the cross-section of the distribution pipes 106 allow to place the outlets or nozzles of neighboring distribution pipes close to each other. According to some embodiments, which can be combined with other embodiments described herein, a first outlet or nozzle of the first distribution pipe and a second outlet or nozzle of the second distribution pipe can have a distance of 25 mm or below, such as from 5 mm to 25 mm. More specifically, the distance of the first outlet or nozzle to a second outlet or nozzle can be 10 mm or below.

According to yet further embodiments, which can be combined with other embodiments described herein, tube extensions of the nozzles 312 can be provided. In light of the small distance between the distribution pipes, such tube extensions can be sufficiently small to avoid clogging or condensation therein. Tube extensions can be designed such that nozzles of two or even three sources can be provided in one line above each other, i.e. in one line along the extension of the distribution pipe, which can be a vertical extension. With this special design it is even possible to arrange the nozzles of the two or three sources in one line over small tube extensions, so that a perfect mixing is achieved.

FIG. 5C further illustrates the reduced heat load according to embodiments described herein. A deposition area 312 is shown in FIG. 5C. Typically a substrate can be provided in the deposition area for deposition of metallic material on a substrate. The angle 395 between the sidewall 326 and the deposition area 312 is indicated in FIG. 5C. As can be seen, the sidewall 326 is inclined by a comparably large angle such that the heat radiation, which might occur in spite of the heat shields and cooling elements is not directly radiated towards the deposition area. According to some embodiments, which can be combined with other embodiments described herein, the angle 395 can be 15° or more. Accordingly, the dimension or area, which is indicated by arrow 392, is significantly smaller as compared to the dimension or area, which is indicated by arrow 394. , The dimension indicated by arrow 392 corresponds to the dimension of the cross-section of the distribution pipes 106, for which the surface facing the deposition area is essentially parallel or has an angle of 30° or less or even 15° or less. The corresponding area, i.e. the area which provides direct heat load to the substrate, is the dimension shown in FIG. 5C multiplied with the length of the distribution pipes. The dimension indicated by arrow 394 is a projection on the deposition area 312 of the entire evaporation source in the respective cross-section. The corresponding area, i.e. the area of the projection onto the surface of the deposition area, is the dimension (arrow 394) shown in FIG. 5C multiplied with the length of the distribution pipes. According to embodiments described herein, which can be combined with other embodiments described herein, the area indicated by arrow 392 can be 30% or less as compared to the area indicated by arrow 394. In light of the above, the shape of the distribution pipes 106 reduces the direct heat load radiated towards the deposition area. Accordingly, temperature stability of the substrate and a mask provided in front of the substrate can be improved.

FIG. 6 illustrates yet further optional modifications of evaporation sources according to embodiments described herein. FIG. 6 shows a cross-section of a distribution pipe 106. Walls of the distribution pipe 106 surround the inner hollow space 710. The first inner tube 232 is arranged within the first outer tube. Vapor can exit the hollow space through nozzle 312. In order to improve heating of the nozzle 312, a nozzle support 412 is provided, which is in contact with the heated walls of the distribution pipe 106. The outer shield 402, which surrounds the distribution pipe 106 is a cooled shield for further reducing the heat load. Further, a cooled shield 404 is provided to additionally reduce the heat load directed towards the deposition area or a substrate, respectively.

According to some embodiments, which can be combined with other embodiments described herein, the cooled shields can be provided as metal plates having conduits for cooling fluid, such as water, attached thereto or provided therein. Additionally, or alternatively, thermoelectric cooling means or other cooling means can be provided to cool the cooled shields. Typically, the outer shields, i.e. the outermost shields surrounding the inner hollow space of a distribution pipe, can be cooled.

Fig. 6 illustrates a further aspect, which can be provided according to some embodiments. Shaper shields 405 are shown in FIG. 6. The shaper shields typically extend from a portion of the evaporation source towards the substrate or the deposition area. Accordingly, the direction of the vapor exiting the distribution pipe or pipes through the outlets can be controlled, i.e. the angle of the vapor emission can be reduced. According to some embodiments, at least a portion of the metallic material evaporated through the outlets or nozzles is blocked by the shaper shield. By such an arrangement, the width of the emission angle can be controlled. According to some implementations, the shaper shields 405 can be cooled similar to the cooled shields 402 and 404 in order to further reduce the heat radiation emitted towards the deposition area.

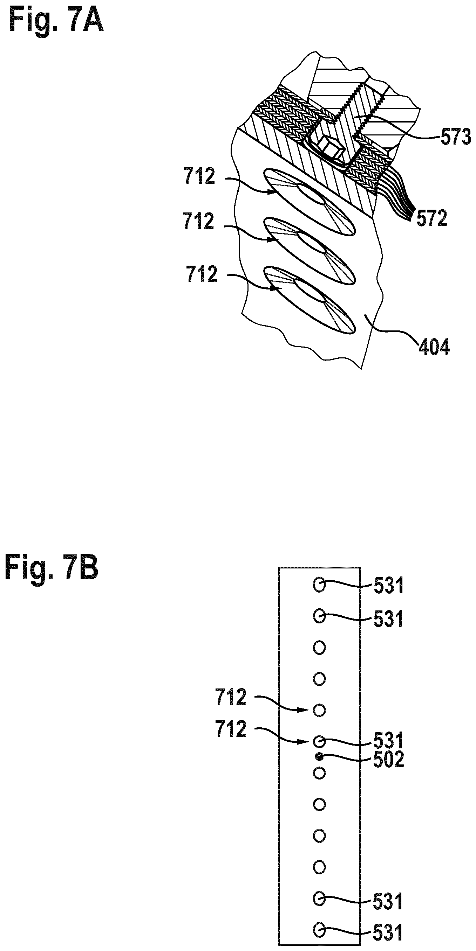

FIG. 7A shows a portion of an evaporation source. According to some embodiments, which can be combined with other embodiments described herein, the evaporation source or the evaporation source array is a vertical linear source. Accordingly, the three outlets 712 are a portion of a vertical outlet array. FIG. 7A illustrates a stack of heat shields 572, which can be attached to the distribution pipe by fixation element 573, e.g. a screw or the like. Further, the outer shield 404 is a cooled shield having further openings provided therein. According to some embodiments, which can be combined with other embodiments described herein, the design of the outer shield can be configured to allow for thermal extension of the components of the evaporation source, wherein the openings maintain alignment with the nozzles of the distribution pipe or reach alignment with the nozzles of the distribution pipe when the operation temperature is reached. FIG. 7B shows a side view of a cooled outer shield 404. The cooled outer shield can essentially extend along the length of the distribution pipe. Alternatively, two or three cooled outer shields can be provided next to each other to extend along the length of the distribution pipe. The cooled outer shield is attached to the evaporation source by fixation element 502, e.g. a screw, wherein the fixation element is provided essentially in the center (± 10 % or ± 20 %) of the distribution pipe along the length extension. Upon thermal expansion of the distribution pipe, the length of the portion of the outer shield 404, which is subject to thermal extension, is reduced. The openings 531 in the outer shield 404 can be circular when close to the fixation element 502 and can have an oval shape when at a greater distance from the fixation element. According to some embodiments, the length of the openings 531 in a direction parallel to the longitudinal axis of the evaporation pipe can be increased the larger the distance from the fixation element is. Typically, the width of the openings 531 in a direction perpendicular to the longitudinal axis of the evaporation pipe can be constant. In light of the above, the outer shield 404 can extend upon thermal expansion particularly along the longitudinal axis of the evaporation pipe and the increased dimension parallel to the longitudinal axis of the evaporation pipe can compensate or at least partially compensate for the thermal expansion. Accordingly, the evaporation source can be operated in a wide temperature range without the openings in the outer shield 404 blocking the nozzles.

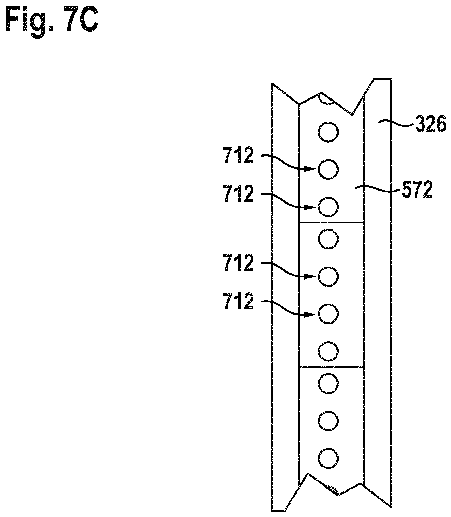

FIG. 7C illustrates a further optional feature of embodiments described herein, which can likewise also be provided for other embodiments described herein. FIG. 7C shows a side view from the side of wall 322 (see FIG. 5A), wherein a shield 572 is provided at the wall 322. Further, the side wall 326 is shown in FIG. 7C. As can be seen in FIG. 7C the shield 572 or the shields in the stack of shields are segmented along the length of the evaporation pipe. The length of shield portion can be 200 mm or below, e.g. 120 mm or below, such as 60 mm to 100 mm. Accordingly, the length of the shield portions, e.g. the stack of shields is reduced in order to reduce thermal expansion thereof. Accordingly, the alignment of the openings in the shield, through which the nozzles can extend and which correspond to the outlets 712, is less critical.

According to yet further embodiments, which can be combined with other embodiments described herein, two or more heat shields 372 are provided around the inner hollow space 710 and the heated portion of the distribution pipe 106. Accordingly, the heat radiation towards the substrate, the mask or another portion of a deposition apparatus from the heated portion of the distribution pipe 106 can be reduced. According to one example, as shown in FIG. 7A, more layers of heat shields 572 can be provided at the side at which the openings or outlets are provided. A stack of heat shields is provided. According to typical embodiments, which can be combined with other embodiments described herein, the heat shields 372 and/or 572 are spaced apart from each other, for example by 0.1 mm to 3 mm. According to some embodiments, which can be combined with other embodiments described herein, the stack of heat shields is designed as described with respect to FIGS. 7A to 7C such that the stack of heat shields compensates for the thermal expansion of the source during the process, so that the nozzles are never blocked. Additionally the outermost shield can be cooled, e.g. water cooled. Thus, according to some embodiments, an outer shield 404, particularly at the side at which the openings are provided, can be a cooled shield, e.g. having cone shaped openings provided therein. Accordingly, such an arrangement allows for a temperature stability with a deviation of ΔT of 1°C even if the nozzles have a temperature of about 1300 °C.

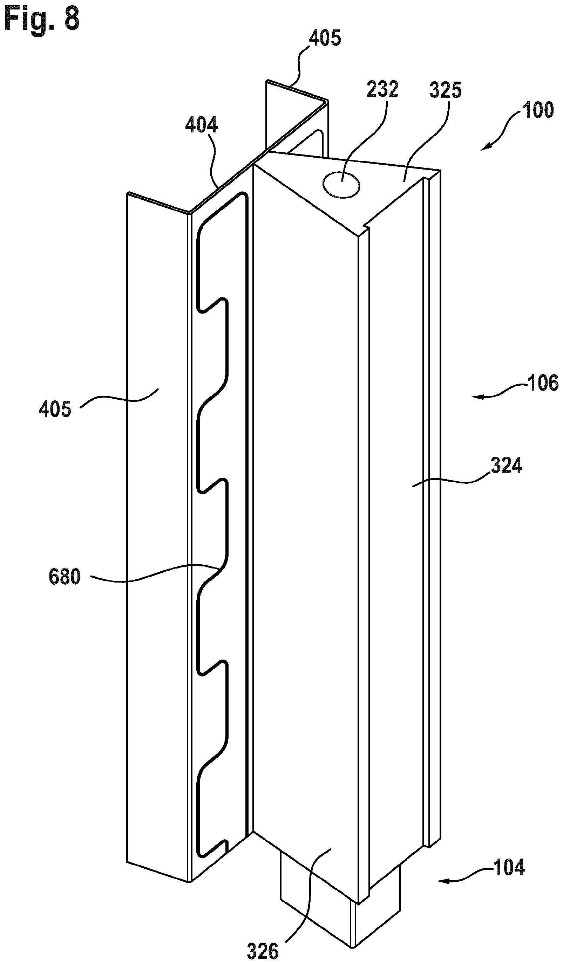

FIG. 8 shows a further view of an evaporation source 100. An evaporation crucible 104 is provided for evaporating the metallic material. A second heating element is provided inside the second inner tube 244 (both not shown in FIG. 8) for heating the evaporation crucible 104. The distribution pipe 106 is in fluid communication with the evaporation crucible, such that metallic material evaporated in the evaporation crucible can be distributed in the distribution pipe 106. The evaporated metallic material exits the distribution pipe 106 through openings (not shown in FIG. 8.). Distribution pipe 106 has sidewalls 326, a wall 324 opposing the wall at the outlet side and a top wall 325. Top wall 325 and the first inner tube 232 are joined e.g. by welding, for example such that no openings like slits or gaps are provided. A first heating element (not shown in FIG. 8) is arranged inside the first inner tube 232 of distribution pipe 106. According to some embodiments, which can be combined with other embodiments described herein, the evaporation source and/or one or more of the walls respectively, can be made of molybdenum or tantalum. Specifically, the evaporation source and/or one or more of the walls can be made of molybdenum or tantalum. Both sections, the evaporation crucible 104 and the distribution pipe 106, can be heated independently from each other.

Shield 404, which further reduces the heat radiation towards the deposition area, is cooled by cooling element 680. For example, conduits for having a cooling fluid provided therein can be mounted to the shield 404. As shown in FIG. 8, shaper shields 405 can additionally be provided at the cooling shield 404. According to some embodiments, which can be combined with other embodiments described herein, the shaper shield can also be cooled, e.g. water cooled. For example, the shaper shield can be attached to the cooling shield or cooling shield arrangement. The thickness uniformity of the deposited film of metallic material can be tuned over the nozzle array and additional shaper shields, which can be placed aside of the one or more outlets or nozzles. The compact design of the source allows for moving the source with a driving mechanism in a vacuum chamber of a deposition apparatus. In this case all controllers, power supplies and additional support functions are implemented in an atmospheric box, which is attached to the source.

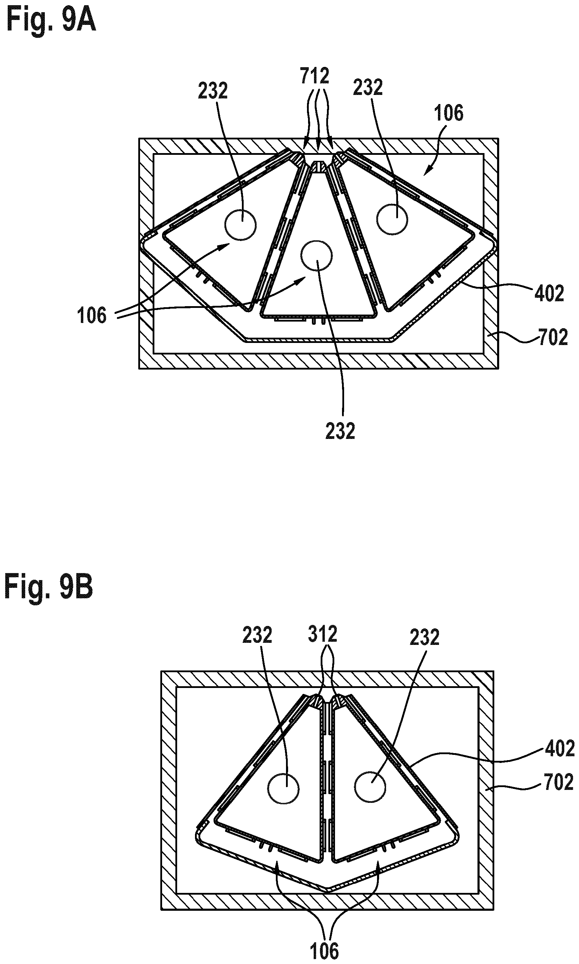

FIGS. 9A and 9B show further top views including a cross-section of distribution pipes 106. FIG. 9A shows an embodiment having three distribution pipes 106, which are provided over an evaporator control housing 702. The evaporator control housing is configured to maintain atmospheric pressure therein and is configured to house at least one element selected from the group consisting of: a switch, a valve, a controller, a cooling unit, a cooling control unit, a heating control unit, a power supply, and a measurement device. Accordingly, a component for operating the evaporation source for the evaporation source array can be provided under atmospheric pressure close to the evaporation crucible and the distribution pipe and can be moved through the deposition apparatus together with the evaporation source.

The distribution pipes 106 shown in FIG. 9A are heated by first heating elements which are provided inside the first inner tubes 232. A cooled shield 402 is provided surrounding the distribution pipes 106. According to some embodiments, which can be combined with other embodiments described herein, one cooled shield can surround two or more distribution pipes 106. The metallic materials, which are evaporated in an evaporation crucible are distributed in a respective one of the distribution pipes 106 and can exit the distribution pipe through outlets 712. Typically, a plurality of outlets is distributed along the length of the distribution pipe 106. FIG. 9B shows an embodiment similar to FIG. 9A, wherein two distribution pipes are provided. The outlets are provided by nozzles 312. Each distribution pipe is in fluid communication with the evaporation crucible (not shown in FIGS. 9A and 9B), wherein the distribution pipe has a cross-section perpendicular to the length of the distribution pipe, which is non-circular, and which includes an outlet side at which the one or more outlets are provided, wherein the width of the outlet side of the cross-section is 30% or less of the maximum dimension of the cross-section.

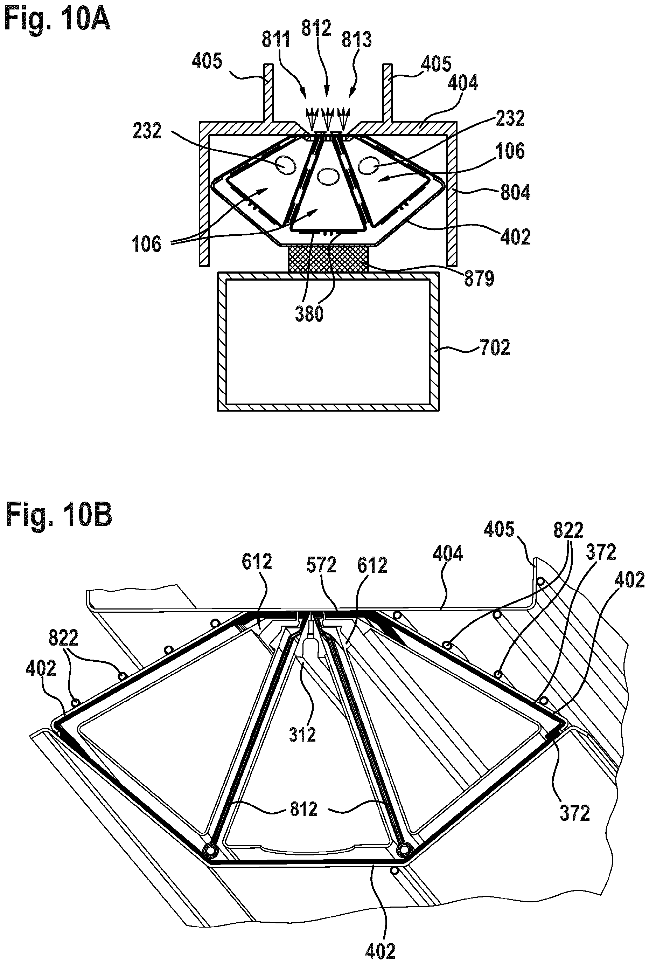

FIG. 10A illustrates yet further embodiments described herein. Three distribution pipes 106 are provided. An evaporator control housing 702 is provided adjacent to the distribution pipes and connected thereto via a thermal insulator 879. As described above, the evaporator control housing, configured to maintain atmospheric pressure therein, is configured to house at least one element selected from the group consisting of: a switch, a valve, a controller, a cooling unit, a cooling control unit, a heating control unit, a power supply, and a measurement device. In addition to the cooled shield 402, the cooled shield 404 is provided, which has sidewalls 804. The cooled shield 404 and the sidewalls 804 provide a U-shaped cooled heat shield to reduce the heat radiation towards the deposition area, i.e. a substrate and/or a mask. Arrows 811, 812, and 813, respectively illustrate evaporated metallic material exiting distribution pipes 106. Due to the essentially triangular shape of the distribution pipes, the evaporation cones originating from the three distribution pipes are in close proximity to each other, such that mixing of the metallic materials from the different distribution pipes can be improved.

As further shown in FIG. 10A, shaper shields 405 are provided, for example, attached to the cooled shield 404 or as a part of the cooled shield 404. According to some embodiments, the shaper shields 405 can also be cooled to further reduce the heat load emitted towards the deposition area. The shaper shields delimit the distribution cone of the metallic materials distributed towards the substrates, i.e. the shaper shields are configured to block at least a portion of the metallic materials.

FIG. 10B shows a cross-sectional view of yet another evaporation source according to embodiments described herein. Three distribution pipes are shown, wherein each distribution pipe is heated by heating elements provided in inner tubes (both not shown in FIG. 10B). The vapor generated in evaporation crucibles (not shown) exit the distribution pipe through nozzles 312 and 612, respectively. In order to have the outlets 712 of the nozzles closer together, the outer nozzles 612 include tube extensions, which include short tubes extending towards the nozzle tubes of the center distribution pipe. According to some embodiments, the tube extensions can have a bend such as a 60° to 120° bend, e.g. a 90° bend. A plurality of shields 572 is provided at the outlet sidewall of the evaporation source. For example, at least 5 or even at least 7 shields 572 are provided at the outlet side of the evaporation tube. A shield 402 is provided to or at the one or more distribution pipes, wherein cooling elements 822 are provided. Between the distribution pipe and the shield 402 a plurality of shields 372 are provided. For example, at least 2 or even at least 5 shields 372 are provided between the distribution pipe and the shield 402. The plurality of shields 572 and the plurality of shields 372 are provided as stacks of shields, e.g. wherein the shields are distant from each other by 0.1 mm to 3 mm.

According to yet further embodiments, which can be combined with other embodiments described herein, a further shield 812 can be provided between the distribution pipes. For example, the further shield 812 can be a cooled shield or a cooled lug. By such further shields, the temperature of the distribution pipes can be controlled independent from each other. For example, in the event different metals are evaporated through neighboring distribution pipes, these metals may need to be evaporated at different temperatures. Accordingly, the further shield 812, e.g. a cooled shield, can reduce cross-talk between the distribution pipes in an evaporation source or an evaporation source array.

The embodiments described herein mostly relate to evaporation sources and evaporation apparatuses for depositing metallic material on a substrate, while the substrate is essentially vertically oriented. The essentially vertical substrate orientation allows for a small footprint of deposition apparatuses and specifically deposition systems including several deposition apparatuses for coating several layers of organic or metallic material on a substrate for OLED production. It can be considered that apparatuses described herein are configured for large area substrate processing or processing of a plurality of substrates in large area carriers. The vertical orientation further allows for a good scalability for current and future substrate size generations, that is present and future glass sizes. Yet, the evaporation sources with the improved cross sectional shape and the concept of heat shields and cooling elements can also be provided for material deposition on horizontal substrates.

FIGS. 11A and 11B show a yet further embodiment of deposition apparatus 500. FIG. 11A shows a schematic top view of the deposition apparatus 500. FIG. 11B shows a schematic cross-sectional side view of the deposition apparatus 500. The deposition apparatus 500 includes a vacuum chamber 110. The valve 205, for example a gate valve, allows for a vacuum seal to an adjacent vacuum chamber. The valve can be open for transport of a substrate 121 or a mask 132 into the vacuum chamber 110 or out of the vacuum chamber 110. Two or more evaporation sources 100 are provided in the vacuum chamber 110. The example shown in FIG. 11A shows seven evaporation sources. According to typical embodiments, which can be combined with other embodiments described herein, to evaporation sources, three evaporation sources, or four evaporation sources can beneficially be provided. As compared to a higher number of evaporation sources, which may also be provided according to some embodiments, the logistics of maintenance of the limited number of evaporation sources (e.g. 2 to 4) might be easier. Accordingly, the cost of ownership might be better for such systems.

According to some embodiments, which can be combined with other embodiments described herein, and as for example shown in FIG. 11A, the looped track 530 can be provided. The looped track 530 can include straight portions 534 and curved portions 533. The looped track 530 provides for a translational movement of the evaporation sources and the rotation of the evaporation sources. As described above, the evaporation sources can typically be line sources, e.g. linear vapor distribution showerheads.

According to some embodiments, which can be combined with other embodiments described herein, the looped track includes a rail or a rail arrangement, a roller arrangement or a magnetic guide to move the one or more evaporation sources along the looped track.

Based upon the looped track 530, a train of sources can move with translational movement along a substrate 121, which is typically masked by a mask 132. The curved portion 533 of the looped track 530 provides a rotation of the evaporation source 100. Further, the curved portion 533 can provide for positioning the evaporation source in front of a second substrate 121. The further straight portion 534 of the looped track 530 provides a further translational movement along the further substrate 121. As mentioned above, according to some embodiments, which can be combined with other embodiments described herein, the substrates 121 and optionally the masks 132 remain essentially stationary during deposition. The evaporation sources providing line sources, e.g. line sources with an essentially vertical orientation of the line, are moved along the stationary substrates.

According to some embodiments, which can be combined with other embodiments described herein, a substrate 121 shown in vacuum chamber 110 can be supported by a substrate support having rollers 403 and 424 and further, in a stationary deposition position, by a substrate support 126, which are connected to alignment units 112. An alignment unit 112 can adjust the position of the substrate 121 with respect to the mask 132. Accordingly, the substrate can be moved relative to the mask 132 in order to provide for a proper alignment between the substrate and the mask during deposition of the metallic material. According to a further embodiment, which can be combined with other embodiments described herein, alternatively or additionally the mask 132 and/or the mask frame 131 holding the mask 132 can be connected to the alignment unit 112. Either the mask can be positioned relative to the substrate 121 or the mask 132 and the substrate 121 can both be positioned relative to each other.

The embodiment shown in FIGS. 11A and 11B shows two substrates 121 provided in the vacuum chamber 110. Yet, particularly for embodiments including a train of evaporation sources 100 in a vacuum chamber at least three substrates or at least four substrates can be provided. In this way, sufficient time for exchange of the substrate, i.e. transport of a new substrate into the vacuum chamber and of a processed substrate out of the vacuum chamber, can be provided even for a deposition apparatus 500 having a larger number of evaporation sources and, thus, a higher throughput.

FIGS. 11A and 11B show the first transportation track for a first substrate 121 and a second transportation track for a second substrate 121. A first roller assembly is shown on one side of the vacuum chamber 110. The first roller assembly includes rollers 424. Further, the transportation system includes a magnetic guiding element 524. Similarly, a second transportation system having rollers and a magnetic guiding element is provided on the opposing side of the vacuum chamber. The upper portions of the carriers 421 are guided by magnetic guiding elements 524. Similarly, according to some embodiments, the mask frames 131 can be supported by rollers 403 and magnetic guiding elements 503.

FIG. 11B exemplarily shows two supports 102 provided on a respective straight portion 534 of the looped track 530. Evaporation crucibles 104 and distribution pipes 106 are supported by the respective supports 102. FIG. 11B illustrates two distribution pipes 106 supported by a support 102. The supports 102 are shown as being guided on the straight portions 534 of the looped track. According to some embodiments, which can be combined with other embodiments described herein, an actuator, a drive, a motor, a drive belt, and/or a drive chain can be provided to move the support 102 along the looped track, i.e. along the straight portions 534 of the looped track and along the curved portion 533 (see FIG. 11A) of the looped track.

According to embodiments of deposition apparatuses described herein, a combination of the translational movement of a line source, e.g. a linear vapor distribution showerhead, and the rotation of the line source, e.g. a linear vapor distribution showerhead, allows for a high evaporation source efficiency and a high material utilization for OLED display manufacturing, wherein a high precision of masking of the substrate is desired. A translational movement of the source allows for high masking precision since the substrate and the mask can maintain stationary. The rotational movement allows for a substrate exchange of one substrate while another substrate is coated with material. This significantly improves the material utilization as the idle time, i.e. the time during which the evaporation source evaporates material without coating a substrate, is significantly reduced.

Embodiments described herein particularly relate to deposition of metallic materials, e.g. for OLED display manufacturing and on large area substrates. According to some embodiments, large area substrates or carriers supporting one or more substrates, i.e. large area carriers, may have a size of at least 0.174 m² or at least 1.4 m². Typically, the size of the carrier can be about 1.4 m² to about 8 m², more typically about 2 m² to about 9 m² or even up to 12 m². Typically, the rectangular area in which the substrates are supported, for which the holding arrangements, apparatuses, and methods according to embodiments described herein are provided, are carriers having sizes for large area substrates as described herein. For instance, a large area carrier, which would correspond to an area of a single large area substrate, can be GEN 5, which corresponds to about 1.4 m² substrates (1.1 m x 1.3 m), GEN 7.5, which corresponds to about 4.29 m² substrates (1.95 m x 2.2 m), GEN 8.5, which corresponds to about 5.7 m² substrates (2.2 m x 2.5 m), or even GEN 10, which corresponds to about 8.7 m² substrates (2.85 m × 3.05 m). Even larger generations such as GEN 11 and GEN 12 and corresponding substrate areas can similarly be implemented. According to typical embodiments, which can be combined with other embodiments described herein, the substrate thickness can be from 0.1 to 1.8 mm and the holding arrangement, and particularly the holding devices, can be adapted for such substrate thicknesses. However, particularly the substrate thickness can be about 0.9 mm or below, such as 0.5 mm or 0.3 mm, and the holding arrangement, and particularly the holding devices, are adapted for such substrate thicknesses. Typically, the substrate may be made from any material suitable for material deposition. For instance, the substrate may be made from a material selected from the group consisting of glass (for instance soda-lime glass, borosilicate glass etc.), metal, polymer, ceramic, compound materials, carbon fiber materials or any other material or combination of materials which can be coated by a deposition process.

In order to achieve good reliability and yield rates, embodiments described herein keep the substrate stationary during the deposition of metallic material. A movable linear source for uniform coating of a large area substrate is provided. The idle time is reduced as compared to an operation wherein after each deposition the substrate needs to be exchanged including a new alignment process of the mask and the substrate relative to each other. During the idle time, the source is wasting material. Accordingly, having a second substrate in a deposition position and readily aligned with respect to the mask reduces the idle time and increases the material utilization.

The embodiments described herein further provide evaporation sources (or evaporation source arrays) having a reduced heat radiation towards the deposition area, i.e. substrate and/or a mask such that the mask can be held at an essentially constant temperature which is within the temperature range of 5°C or below or even within a temperature range of 1°C or below. Yet further, the shape of the distribution pipe or distribution pipes with the small width at the outlet side reduces the heat load on the mask and further improves mixing of different metallic materials because the outlets of neighboring distribution pipes can be provided in close proximity, e.g. at a distance of 25 mm or below.

According to typical embodiments, which can be combined with other embodiments described herein, an evaporation source includes at least one evaporation crucible, and at least one distribution pipe, e.g. at least one linear vapor distribution showerhead. However, an evaporation source can include two or three, eventually even four or five evaporation crucibles and corresponding distribution pipes. With an evaporation source including at least two of the several distribution pipes, different metallic materials can be evaporated in at least two of the several crucibles, such that the different metallic materials form one metallic layer or metal alloy layer on the substrate. Additionally or alternatively, similar metallic materials can be evaporated in at least two of the several crucibles, such that the deposition rate can be increased.

According to embodiments described herein, the evaporation sources, the deposition apparatuses, the methods of operating evaporation sources and/or deposition apparatuses, and the methods of manufacturing evaporation sources and/or deposition apparatuses are configured for a vertical deposition, i.e. the substrate is supported in an essentially vertical orientation (e.g. vertical ±10°), during layer deposition. Further, a combination of a line source, a translational movement and a rotation of the evaporation direction, particularly a rotation around an axis being essentially vertical, e.g. parallel to the substrate orientation and/or the direction of the line-extension of the line source, allows for a high material utilization of about 80% or above. This is an improvement of at least 30% as compared to other systems.

A movable and turnable evaporation source within the process chamber, i.e. the vacuum chamber for layer deposition therein, allows for a continuous or almost continuous coating with high material utilization. Generally, embodiments described herein allow for a high evaporation source efficiency (>85%) and a high material utilization (at least 50% or above) by using a scanning source approach with 180° turning mechanism to coat two substrates alternating. Source efficiency as described herein takes into consideration material losses occurring due to the fact that the vapor beams extend over the size of the large area substrates in order to allow for a uniform coating of the entire area of the substrate which is to be coated. The material utilization additionally considers losses occurring during idle times of the evaporation source, i.e. times where the evaporation source cannot deposit the evaporated material on a substrate.

Yet further, the embodiments described herein and relating to a vertical substrate orientation allow for a small footprint of the deposition apparatuses and specifically of deposition systems including several deposition apparatuses for coating several layers of organic and metallic material on a substrate. It can be considered that apparatuses described herein are configured for large area substrate processing or processing of a plurality of substrates in large area carriers. The vertical orientation further allows for a good scalability for current and future substrate size generations, that is present and future glass sizes.

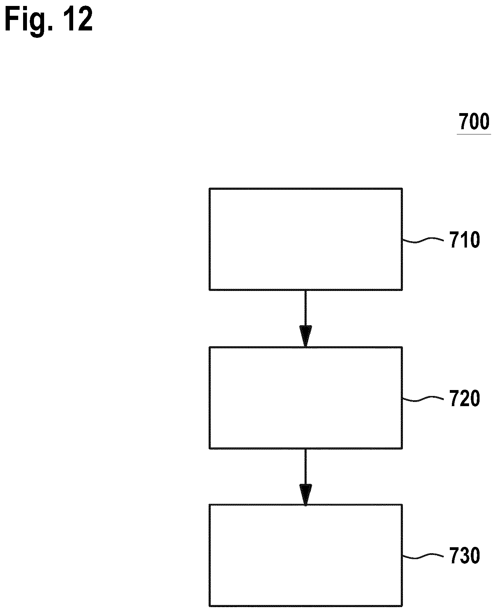

FIG. 12 shows a flowchart of a method 700 for depositing of a metallic material, e.g. a metal or a metal alloy, with a distribution pipe according to embodiments described herein. The distribution pipe may be arranged in a vacuum tool for the manufacture of organic light-emitting diodes (OLED).

According to an aspect of the present disclosure, the method 700 includes in block 710 evaporating a first metal or metal alloy with a first evaporation source. According to some embodiments, the method 700 further includes a block 720, evaporating a second metal or metal alloy with a second evaporation source. According to embodiments described herein, the method 700 further includes in block 730, forming a layer on a substrate comprising the first metal or metal alloy evaporated with the first evaporation source. According to an alternative embodiment described herein, block 730 of method 700 describes forming a layer on a substrate comprising the second metal or metal alloy evaporated with the second evaporation source. According to yet another embodiment, block 730 of method 700 further includes the process of forming a layer on a substrate including a mixture of the first metal or metal alloy and the second metal or metal alloy evaporated with the first and the second evaporation source, respectively. According to an embodiment, the evaporated material of the first evaporation source may be silver (Ag). According to another embodiment, the evaporated material of the second evaporation source may be magnesium (Mg). The evaporated material of the first evaporation source, e.g. Ag, and the evaporated material of the second evaporation source, e.g. Mg may be evaporated in a ratio of 1:2 ≤ Ag : Mg ≤ 7:1, particularly in a ratio of 1:1 ≤ Ag : Mg ≤ 7:1, more particularly in a ratio of 1:1 ≤ Ag : Mg ≤ 5:1.

According to embodiments described herein, the substrates are coated with metallic material in an essentially vertical position. The distribution pipe provides a line source extending essentially vertically. According to embodiments described herein, which can be combined with other embodiments described herein, essentially vertically is understood particularly when referring to the substrate orientation, to allow for a deviation from the vertical direction of 20° or below, e.g. of 10° or below. This deviation from the vertical direction can be used to reduce particle generation on the substrate or layers deposited thereon. According to different embodiments, which can be combined with other embodiments described herein, the evaporation source may be provided in the vacuum chamber on a track, e.g. a looped track or linear guide. The track or the linear guide is configured for the translational movement of the evaporation source. A drive for the translational movement can be provided in the evaporation source, at the track or linear guide, within the vacuum chamber or a combination thereof.

While the foregoing is directed to embodiments of the invention, other and further embodiments of the invention may be devised without departing from the scope thereof, and the scope thereof is determined by the claims that follow.

## Claims

1. An evaporation source for a metal or a metal alloy, comprising:
an evaporation crucible configured to evaporate the metal or metal alloy;
a distribution pipe in fluid communication with the evaporation crucible comprising one or more outlets provided along the length of the distribution pipe and a first outer tube and a first inner tube,
wherein the distribution pipe and the evaporation crucible are provided as one single piece or are non-detachably connected.

2. The evaporation source according to claim 1, wherein the evaporation crucible further comprises a second outer tube and a second inner tube.

3. The evaporation source according to claim 1 or 2, wherein the evaporation crucible and the distribution pipe are connected by one of a welded or sintered joint.

4. The evaporation source according to any of claims 1 to 3, wherein the distribution pipe further comprises a first heating element which is arranged inside the first inner tube and/or wherein the evaporation crucible further comprises a second heating element which is arranged inside the second inner tube.

5. The evaporation source according to any of claims 1 to 4, wherein the evaporation crucible and the distribution pipe are made of molybdenum or tantalum.

6. The evaporation source according to any of claims 1 to 5, wherein the one or more outlets comprises nozzles.

7. The evaporation source according to claim 6, wherein the nozzles extend in an essentially horizontal direction.

8. The evaporation source according to any of claims 1 to 7, wherein the distribution pipe is a vapor distribution showerhead including the one or more outlets.

9. The evaporation source according to claim 8, the vapor distribution showerhead is a linear vapor distribution showerhead.

10. The evaporation source according to claim 9, wherein the linear vapor distribution showerhead providing a linear source for vapor of the metal or metal alloy.

11. The evaporation source according to any of claims 1 to 10, wherein the distribution pipe comprises a sealable opening for filling of evaporation material into the evaporation source.

12. An evaporation source array for metals or metal alloys, comprising:
a first evaporation source according to any of claims 1 to 11; and
at least a second evaporation source according to any of claims 1 to 11.

13. The evaporation source array according to claim 12, wherein at least a first outlet of the one or more outlets of the first evaporation source and at least a second outlet of the one or more outlets of the second evaporation source are spaced apart by 25 mm or less.

14. The evaporation source array according to any of claims 12 or 13, wherein the distribution pipes are rotatable around an axis during evaporation; and further comprising:
one or more supports for the distribution pipes connectable to a first drive or including the first drive and configured for a translational movement of the one or more supports and the distribution pipes.

15. A Method of operating an evaporation source array according to any of claims 13 to 14, wherein the evaporated material of the first evaporation source is Ag and the evaporated material of the second evaporation source is Mg.

16. Method of operating an evaporation source array according to claim 15, wherein the evaporated material of the first evaporation source and the evaporated material of the second evaporation source are evaporated in a ratio of 1:1 ≤ Ag : Mg ≤ 7:1

17. The evaporation source according to any of claims 1 to 11, wherein the distribution pipe has a non-circular cross-section in the direction perpendicular to the length of the distribution pipe comprising a main section corresponding to a portion of a triangle, particularly wherein the cross-section of the distribution pipe in the direction perpendicular to the length of the distribution pipe is triangular with rounded corners and/or cut-off corners.

18. The evaporation source according to claim 17, wherein the cross-section of the distribution pipe in the direction perpendicular to the length of the distribution pipe is a truncated triangle, and the face of the truncated portions includes at least one flow passage extending therethrough.

19. The evaporation source according to claim 1, wherein the crucible comprises an inner tube surrounding a first space, an outer tube surrounding the inner tube, and a bottom plate, and a heater disposed in the first space.

20. The evaporation source according to claim 19, wherein the inner tube surrounding a first space, the outer tube and the bottom plate form a receptacle to hold an evaporable material.

## Patentansprüche

1. Verdampfungsquelle für ein Metall oder eine Metalllegierung, umfassend:
einen Verdampfungstiegel, der dazu ausgestaltet ist, das Metall oder die Metalllegierung zu verdampfen;
eine Verteilungsleitung in Fluidverbindung mit dem Verdampfungstiegel, die einen oder mehrere Auslässe, die entlang der Länge der Verteilungsleitung vorgesehen sind, und ein erstes äußeres Rohr und ein erstes inneres Rohr umfasst,
wobei die Verteilungsleitung und der Verdampfungstiegel als ein einziges Teil bereitgestellt oder nicht lösbar verbunden sind.

2. Verdampfungsquelle nach Anspruch 1, wobei der Verdampfungstiegel ferner ein zweites äußeres Rohr und ein zweites inneres Rohr umfasst.

3. Verdampfungsquelle nach Anspruch 1 oder 2, wobei der Verdampfungstiegel und die Verteilungsleitung durch eine Schweißverbindung oder eine Sinterverbindung verbunden sind.

4. Verdampfungsquelle nach einem der Ansprüche 1 bis 3, wobei die Verteilungsleitung ferner ein erstes Heizelement umfasst, das im Inneren des ersten inneren Rohrs angeordnet ist, und/oder wobei der Verdampfungstiegel ferner ein zweites Heizelement umfasst, das im Inneren des zweiten inneren Rohrs angeordnet ist.

5. Verdampfungsquelle nach einem der Ansprüche 1 bis 4, wobei der Verdampfungstiegel und die Verteilungsleitung aus Molybdän oder Tantal hergestellt sind.

6. Verdampfungsquelle nach einem der Ansprüche 1 bis 5, wobei der eine oder die mehreren Auslässe Düsen umfassen.

7. Verdampfungsquelle nach Anspruch 6, wobei die Düsen sich in einer im Wesentlichen horizontalen Richtung erstrecken.

8. Verdampfungsquelle nach einem der Ansprüche 1 bis 7, wobei die Verteilungsleitung ein Dampfverteilungssprühkopf ist, der den einen oder die mehreren Auslässe aufweist.

9. Verdampfungsquelle nach Anspruch 8, wobei der Dampfverteilungssprühkopf ein linearer Dampfverteilungssprühkopf ist.

10. Verdampfungsquelle nach Anspruch 9, wobei der lineare Dampfverteilungssprühkopf eine lineare Quelle für Dampf des Metalls oder der Metalllegierung bereitstellt.

11. Verdampfungsquelle nach einem der Ansprüche 1 bis 10, wobei die Verteilungsleitung eine dicht verschließbare Öffnung zum Einfüllen von Verdampfungsmaterial in die Verdampfungsquelle umfasst.

12. Verdampfungsquellenanordnung für Metalle oder Metalllegierungen, umfassend:
eine erste Verdampfungsquelle nach einem der Ansprüche 1 bis 11; und
wenigstens eine zweite Verdampfungsquelle nach einem der Ansprüche 1 bis 11.

13. Verdampfungsquellenanordnung nach Anspruch 12, wobei wenigstens ein erster Auslass des einen oder der mehreren Auslässe der ersten Verdampfungsquelle und wenigstens ein zweiter Auslass des einen oder der mehreren Auslässe der zweiten Verdampfungsquelle 25 mm oder weniger voneinander beabstandet sind.

14. Verdampfungsquellenanordnung nach einem der Ansprüche 12 oder 13, wobei die Verteilungsleitungen während der Verdampfung um eine Achse herum drehbar sind; und ferner umfassend:
einen oder mehrere Träger für die Verteilungsleitungen, die mit einem ersten Antrieb verbindbar sind oder den ersten Antrieb aufweisen und für eine Translationsbewegung des einen oder der mehreren Träger und der Verteilungsleitungen ausgestaltet sind.

15. Verfahren zum Betreiben einer Verdampfungsquellenanordnung nach einem der Ansprüche 13 bis 14, wobei das verdampfte Material der ersten Verdampfungsquelle Ag ist und das verdampfte Material der zweiten Verdampfungsquelle Mg ist.

16. Verfahren zum Betreiben einer Verdampfungsquellenanordnung nach Anspruch 15, wobei das verdampfte Material der ersten Verdampfungsquelle und das verdampfte Material der zweiten Verdampfungsquelle in einem Verhältnis von 1:1 ≤ Ag : Mg ≤ 7:1 verdampft werden.

17. Verdampfungsquelle nach einem der Ansprüche 1 bis 11, wobei die Verteilungsleitung in der Richtung senkrecht zur Länge der Verteilungsleitung einen nicht kreisförmigen Querschnitt aufweist, der einen Hauptabschnitt umfasst, der einem Abschnitt eines Dreiecks entspricht, insbesondere wobei der Querschnitt der Verteilungsleitung in der Richtung senkrecht zur Länge der Verteilungsleitung dreieckig mit abgerundeten Ecken und/oder abgeschnittenen Ecken ist.

18. Verdampfungsquelle nach Anspruch 17, wobei der Querschnitt der Verteilungsleitung in der Richtung senkrecht zur Länge der Verteilungsleitung ein abgeschnittenes Dreieck ist und die Fläche der abgeschnittenen Abschnitte wenigstens einen Strömungsdurchlass aufweist, der sich durch diese hindurch erstreckt.

19. Verdampfungsquelle nach Anspruch 1, wobei der Tiegel ein inneres Rohr, das einen ersten Raum umgibt, ein äußeres Rohr, welches das innere Rohr umgibt, und eine Bodenplatte und eine Heizeinrichtung, die in dem ersten Raum angeordnet ist, umfasst.

20. Verdampfungsquelle nach Anspruch 19, wobei das innere Rohr, das einen ersten Raum umgibt, das äußere Rohr und die Bodenplatte einen Behälter zum Aufnehmen eines verdampfbaren Materials ausbilden.

## Revendications

1. Source d'évaporation destinée à un métal ou à un alliage de métal, comprenant :
un creuset d'évaporation conçu pour évaporer le métal ou l'alliage métallique ;
un tuyau de distribution en communication fluidique avec le creuset d'évaporation comprenant une ou plusieurs sorties disposées le long de la longueur du tuyau de distribution et un premier tube extérieur et un premier tube intérieur,
sachant que le tuyau de distribution et le creuset d'évaporation sont fournis comme une pièce unique ou sont reliés de manière non détachable.

2. Source d'évaporation selon la revendication 1, sachant que le creuset d'évaporation comprend en outre un second tube extérieur et un second tube intérieur.

3. Source d'évaporation selon la revendication 1 ou 2, sachant que le creuset d'évaporation et le tuyau de distribution sont reliés soit par un joint soudé, soit par un joint fritté.

4. Source d'évaporation selon l'une quelconque des revendications 1 à 3, sachant que le tuyau de distribution comprend en outre un premier élément de chauffage agencé à l'intérieur du premier tube intérieur et/ou sachant que le creuset d'évaporation comprend en outre un second élément de chauffage agencé à l'intérieur du second tube intérieur.

5. Source d'évaporation selon l'une quelconque des revendications 1 à 4, sachant que le creuset d'évaporation et le tuyau de distribution sont fabriqués à partir de molybdène ou de tantale.

6. Source d'évaporation selon l'une quelconque des revendications 1 à 5, sachant que les une ou plusieurs sorties comprennent des buses.

7. Source d'évaporation selon la revendication 6, sachant que les buses s'étendent dans une direction essentiellement horizontale.

8. Source d'évaporation selon l'une quelconque des revendications 1 à 7, sachant que le tuyau de distribution est une tête de douche de distribution de vapeur incluant l'une ou plusieurs sorties.

9. Source d'évaporation selon la revendication 8, la tête de douche de distribution de vapeur est une tête de douche linéaire de distribution de vapeur.

10. Source d'évaporation selon la revendication 9, sachant que la tête de douche linéaire de distribution de vapeur fournit une source linéaire pour la vapeur du métal ou de l'alliage métallique.

11. Source d'évaporation selon l'une quelconque des revendications 1 à 10, dans laquelle le tuyau de distribution comprend une ouverture scellable destinée au remplissage de matériau d'évaporation dans la source d'évaporation.

12. Réseau de sources d'évaporation destiné à des métaux ou des alliages métalliques, comprenant :
une première source d'évaporation selon l'une quelconque des revendications 1 à 11 ; et
au moins une seconde source d'évaporation selon l'une quelconque des revendications 1 à 11.

13. Réseau de sources d'évaporation selon la revendication 12, sachant qu'au moins une première sortie de l'une ou plusieurs sorties de la première source d'évaporation et au moins une seconde sortie de l'une ou plusieurs sorties de la seconde source d'évaporation sont espacées l'une de l'autre de 25 mm ou moins.

14. Réseau de sources d'évaporation selon la revendication 12 ou 13, dans lequel les tuyaux de distribution peuvent être mis en rotation autour d'un axe pendant l'évaporation ; et comprenant en outre :
un ou plusieurs supports pour les tuyaux de distribution pouvant être reliés à un premier système d'entraînement ou comprenant le premier système d'entraînement et configuré pour un mouvement de translation de l'un ou plusieurs supports et des tuyaux de distribution.

15. Procédé de fonctionnement d'un réseau de sources d'évaporation selon l'une quelconque des revendications 13 à 14, sachant que le matériau évaporé provenant de la première source d'évaporation est Ag et le matériau évaporé provenant de la seconde source d'évaporation est Mg.

16. Procédé de fonctionnement d'un réseau de sources d'évaporation selon la revendication 15, sachant que le matériau évaporé provenant de la première source d'évaporation et le matériau évaporé provenant de la seconde source d'évaporation sont évaporés dans un rapport de 1:1 ≤ Ag : Mg ≤ 7:1.

17. Source d'évaporation selon l'une quelconque des revendications 1 à 11, sachant que le tuyau de distribution présente une section transversale non circulaire dans la direction perpendiculaire à la longueur du tuyau de distribution comprenant une section principale correspondant à une partie d'un triangle, particulièrement sachant que la section transversale du tuyau de distribution dans la direction perpendiculaire à la longueur du tuyau de distribution est triangulaire avec des coins arrondis et/ou avec des coins découpés.

18. Source d'évaporation selon la revendication 17, sachant que la section transversale du tuyau de distribution dans la direction perpendiculaire à la longueur du tuyau de distribution est un triangle tronqué, et la face des parties tronquées comprend au moins un passage d'écoulement s'étendant à travers celles-ci.

19. Source d'évaporation selon la revendication 1, sachant que le creuset comprend un tube intérieur entourant un premier espace, un tube extérieur entourant le tube intérieur, et une plaque de fond, et un appareil de chauffage disposé dans le premier espace.

20. Source d'évaporation selon la revendication 19, sachant que le tube intérieur entourant un premier espace, le tube extérieur et la plaque de fond forment un réceptacle destiné à recevoir un matériau pouvant s'évaporer.
